# EUROPÄISCHE PATENTANMELDUNG

(11) **EP 1 641 020 A2**
(43) Veröffentlichungstag der Anmeldung: **29.03.2006**
(21) Anmeldenummer: 05028138.5
(22) Anmeldetag: 18.10.2002
(51) Int. Cl.: H01J 37/153

(54) **Korrektor zur Korrektion von Farbfehlern erster Ordnung ersten Grades**

(30) Priorität: 04.12.2001 DE 10159454
(62) Teilanmeldung aus: 02023323.5
(71) Anmelder: Carl Zeiss NTS GmbH, 73447 Oberkochen (DE)
(72) Erfinder: Rose, Harald, 64287 Darmstadt (DE)
(74) Vertreter: Gnatzig, Klaus

(57) **Zusammenfassung**

Die Erfindung betrifft einen Korrektor zur Korrektur von energieabhängigen Aberrationen erster Ordnung, ersten Grades sowie des Öffnungsfehlers dritter Ordnung von elektronenoptischen Linsensystemen. Der Korrektor enthält mindestens ein Quadrupol-Septuplet (S1) mit sieben Quadrupolen (Q1 - Q7), wobei die Quadrupole symmetrisch zu einer Mittelebene (ZS) entlang einer geraden Achse erregbar angeordnet sind. Der Korrektor enthält weiterhin mindestens fünf innerhalb des Quadrupol-Septuplets erregbare Oktupole (O1 - O7).

Bei einer vorteilhaften Ausführungsform sind zwei Quadrupol-Septuplets seriell hinter einander angeordnet, wobei die Quadrupolfelder der beiden Quadrupol-Septuplets antisymmetrisch zu einer zwischen beiden Quadrupol-Septuplets liegenden Mittelebene erregt sind. Mit einem solchen System können neben den axialen und außeraxialen Farbfehlern erster Ordnung und ersten Grades sämtliche geometrischen Aberrationen dritter Ordnung und weitere energieabhängige Aberrationen erster Ordnung, dritten Grades und geometrische Aberrationen fünfter Ordnung eines Linsensystems korrigiert werden.

## Beschreibung

Die vorliegende Erfindung betrifft einen Korrektor zur Korrektion von Farbfehlern erster Ordnung, ersten Grades sowie geometrischer Aberrationen dritter Ordnung von elektronenoptischen Linsensystemen.

Ein entsprechender Korrektor ist aus der DE 42 04 512 A1 bekannt. Der Korrektor enthält insgesamt sechs Quadrupole, deren Potentiale antisymmetrisch zu einer Mittelebene erregt sind, und den Quadrupolen überlagerte Oktupole. Ein weiterer Oktupol ist in der Mittelebene angeordnet. Der Korrektor bildet ein teleskopisches System. Mit diesem Korrektor ist die Korrektur des Öffnungsfehlers dritter Ordnung und des axialen und des außeraxialen chromatischen Farbfehlers erster Ordnung, ersten Grades eines elektronenoptischen Linsensystems möglich. Eine Korrektur der Koma schiefer Bündel ist mit diesem System dadurch möglich, dass der komafreie Punkt der zu korrigierenden Linse in den Knotenpunkt des Korrektors gelegt wird. Nicht korrigierbar sind mit diesem Korrektor außeraxiale geometrische Aberrationen dritter Ordnung, wie der Astigmatismus schiefer Bündel, die Verzeichnung und die Bildfeldwölbung. Insgesamt ist dieses Korrektiv damit nur für Systeme mit relativ kleinen Bildfeldern, wie beispielsweise in Transmissions-Elektronenmikroskopen üblich, einsetzbar, nicht hingegen in Verbindung mit Systemen die große Bildfelder erfordern, wie beispielsweise in der Elektronen-Projektionslithographie.

Es ist das Ziel der vorliegenden Erfindung, einen Korrektor anzugeben, mit dem sowohl die axialen und außeraxialen energieabhängigen Aberrationen erster Ordnung, ersten Grades eines elektronenoptischen Linsensystemes als auch der Öffnungsfehler dritter Ordnung korrigierbar ist und der auch für eine Korrektur der Verzeichnung, der Bildfeldwölbung und des Astimatismus schiefer Bündel des elektronenoptischen Linsensystemes erweiterbar ist. Bei vorteilhaften Ausführungsformen der Erfindung sollen auch die axialen und außeraxialen energieabhängigen Aberrationen erster Ordnung, zweiten Grades und sämtliche geometrischen Aberrationen dritter Ordnung zumindest für eine ausgezeichnete Ebene korrigierbar sein.

Das erstgenannte Ziel wird durch einen Korrektor mit den Merkmalen des Anspruches 1 gelöst. Vorteilhafte Ausgestaltungen der Erfindung ergeben sich aus den Merkmalen der abhängigen Ansprüche.

Der erfindungsgemäße Korrektor weist mindestens sieben Quadrupole, also ein Quadrupol-Septuplet, entlang einer geraden Achse auf, die symmetrisch zu einer Mittelebene entlang der geraden Achse erregbar sind. Weiterhin sind in dem erfindungsgemäßen Korrektor an verschiedenen Stellen innerhalb des Korrektors mindestens fünf Oktupolfelder erregbar.

Erfindungsgemäß wurde erkannt, dass bei einem System mit nur sieben Quadrupolen erreicht werden kann, dass alle axialen oder außeraxialen Fundamentalbahnen entweder symmetrisch oder antisymmetrisch zur Mittelebene des Korrektors verlaufen. Durch diese Symmetrie ist es möglich, den Öffnungsfehler zu korrigieren, ohne Koma und Verzeichnung zusätzlich einzuführen. Soweit das zu korrigierende elektronenoptische Linsensystem eine Koma aufweist, ist die Nullstelle der Feldbahnen des Korrektivs in den komafreien Punkt des Linsensystems bzw. der Linse zu legen, damit auch das Gesamtsystem frei von Koma ist.

Von den insgesamt sieben Quadrupolen sollten mindestens drei elektrisch-magnetisch sein, d.h. aus einer Überlagerung von elektrostatischen und magnetischen Qudrupolfeldern bestehen. Durch die elektrisch-magnetischen Qudrupole ist die Korrektur der axialen energieabhängigen Aberrationen möglich, ohne außeraxiale energieabhängige Aberrationen einzuführen. Aufgrund der Symmetrie der Quadrupole werden in der Knotenebene, in der die Feldstrahlen eine Nullstelle haben, keine außeraxialen energieabhängigen Aberrationen eingeführt. Diese Knotenebene bildet damit eine achromatische Ebene des Korrektors und gleichzeitig eine komafreie Ebene des Korrektors.

Ist eine Anordnung der Knotenebene des Korrektors in der achromatischen Ebene des zu korrigierenden Abbildungsystems nicht möglich, können außeraxiale energieabhängige Aberrationen auch durch eine geeignete Verteilung der magnetischen und elektrischen Quadrupolstärken erreicht werden, indem die elektrischen Quadrupolstärken einen zur Symmetrieebene des Septuplets antisymmetrischen Anteil aufweisen der betragsmäßig gleich aber von der Polarität invers zu einem zur Symmetrieebene des Septuplets antisymmetrischen Anteil der magnetischen Quadrupolstärken ist. Die gesamte Quadrupolstärke ist dann wieder symmetrisch zur Symmetrieebene des Septuplets. Der symmetrische Anteil der elektrischen und magnetischen Quadrupolstärken wird dann in ihrem Verhältnis zueinander so eingestellt, dass der axiale Farbfehler korrigiert wird und der antisymmetrische Anteil der elektrischen und magnetischen Quadrupolstärken wird in ihrem Verhältnis zueinander so eingestellt, dass die außeraxialen Farbfehler korrigiert werden.

Damit der Korrektor keine zusätzliche Koma und Verzeichnung einführt, sollten die Oktupole symmetrisch zur Mittelebene des Quadrupols Septuplets erregt sein.

Um die drei Komponenten des Öffnungsfehlers möglichst unabhängig voneinander zu korrigieren sollte ein erstes Oktupolpaar im Bereich des ersten und letzten Quadrupols, ein zweites Oktupolpaar im Bereich des zweiten und sechsten Quadrupols und ein weiterer Oktupol im Bereich des mittleren Quadrupols erregbar sein. Alternativ zur Erregung des Oktupols im Bereich des mittleren Quadrupols ist es jedoch auch möglich, ein weiteres Oktupolpaar im Bereich des dritten und fünften Quadrupols zu erregen. Eine besonders günstige Entkopplung der Komponenten des Öffnungsfehlers wird erreicht, wenn die Oktupolfelder den Quadrupolfeldern räumlich überlagert sind, dieses ist jedoch nicht zwingend erforderlich, insbesondere sind geringfügige Positionsabweichungen nicht kritisch.

Besonders vorteilhaft ist es, zwei geometrisch gleiche Quadrupol-Septuplets seriell hintereinander entlang der geraden Achse anzuordnen. Mit einer solchen Anordnung ist es dann möglich, alle geometrischen Aberrationen dritter Ordnung sowie die axialen energieabhängigen Aberrationen erster Ordnung, ersten Grades und erster Ordnung, zweiten Grades zu korrigieren. Eine besonders entkoppelte Korrektur aller geometrischen Aberrationen dritter Ordnung wird erreicht, wenn in der Mittelebene zwischen den Quadrupol-Septuplets ein weiterer Oktupol erregbar ist.

Der Korrektor hat zwei ausgezeichnete Anregungsmodi für die Oktupole: In einem ersten ausgezeichneten Anregungsmodus sind die Oktupolfelder in jedem Quadrupol-Septuplet symmetrisch zur Mittelebene des jeweiligen Qudrupol-Septuplets erregt und die Oktupole beider Quadrupol-Septuplets symmetrisch zur Mittelebene zwischen den Quadrupol-Septuplets erregt.

In diesem Betriebsmodus ist der Korrektor komafrei und verzeichnungsfrei, d.h. er führt keine zusätzliche Koma oder Verzeichnung ein.

Im zweiten ausgezeichneten Erregungsmodus sind die Oktupole in jedem Quadrupol-Septuplet antisymmetrisch zur Mittelebene des jeweiligen Quadrupol-Septuplets erregt und die Oktupolfelder beider Qudrupol-Septuplets antisymmetrisch zur Ebene zwischen den Qudrupol-Septuplets erregt. In diesem Betriebsmodus wird kein zusätzlicher Öffnungsfehler, keine Bildfeldwölbung und kein Astigmatismus schiefer Bündel vom Korrektor zusätzlich erzeugt. Welcher Betriebsmodus ausgewählt wird, hängt von den Symmetrieeigenschaften des zu korrigierenden elektronenoptischen Linsensystems ab. Da die Bildfeldwölbung und der Öffnungsfehler elektronenoptischer Rundlinsensysteme unvermeidbar sind, wird in der Praxis die Erregung der Oktupolfelder stets einen symmetrischen Anteil aufweisen. Durch geeignete Überlagerung eines symmetrischen und eines antisymmetrischen Anteils der Oktupolerregungen lassen sich die geometrischen Fehler dritter Ordnung beliebiger Rundlinsensysteme prinzipiell korrigieren.

Weiterhin vorteilhaft ist es, in der Mittelebene zwischen den Quadrupol-Septuplets einen weiteren Oktupol erregbar anzuordnen. Durch diesen zusätzlichen Oktupol zusammen mit den Erregungen der beiden Oktupole in den Symmetrieebenen der Qudrupol-Septuplets ist es möglich, den Öffnungsfehler weitgehend unabhängig von außeraxialen Bildfehlern zu korrigieren.

Weiterhin ist es vorteilhaft, die Oktupolfelder oder zumindest einen Teil der Oktupolfelder durch die Erregung von zwölf Polen oder Multipolen noch höherer Ordnung zu generieren, damit die Orientierung der Oktupolfelder elektrisch um die gerade Achse drehbar ist. Dadurch ist es möglich, die azimutalen Komponenten der Koma, des Astigmatismus schiefer Bündel und der Verzeichnung zu korrigieren.

Weiterhin ist es vorteilhaft, wenn zumindest ein Teil der Oktupolfeler elektisch-magnetisch sind, also ebenfalls aus einer Überlagerung von gekreuzten elektrischen und magnetischen Oktupolfeldern bestehen. Dadurch lassen sich die energieabhängigen Fehler erster Ordnung, dritten Grades teilweise korrigieren und damit reduzieren.

Weiterhin vorteilhaft ist es, sechszählige Multipolfelder zu erzeugen, um die dominanten geometrischen Fehler fünfter Ordnung zu korrigieren.

Die axialen und außeraxialen Fundamentalbahnen sollten beim Korrektor nach der vorliegenden Erfindung in jedem Quadrupol-Septuplet symmetrisch oder antisymmetrisch zur Mittelebene des jeweiligen Quadrupol-Septuplets sein.

Der Verlauf der Fundamentalbahnen im XZ-Schnitt des ersten Septuplets entspricht dem Verlauf der entsprechenden Fundamentalbahnen im YZ-Schnitt des zweiten Septuplets und umgekehrt (wie beim eingangs zitierten Stand der Technik DE 42 04 412).

Ein entsprechender Korrektor, mit dem sämtliche Fehler dritter Ordnung und die energieabhängigen Fehler erster Ordnung, ersten Grades korrigierbar sind, enthält mindestens 14 Quadrupolfelder und 15 Oktupolfelder, die entlang der geraden Achse an unterschiedlichen geeigneten Stellen erregbar sind.

Ein entsprechender Korrektor findet vorzugsweise Anwendung innerhalb eines elektronenoptischen Abbildungssystems, wie dieses beispielsweise in der Elektronen-Projektionslithographie angewendet wird, das eine erste Ebene in eine zweite Ebene verkleinert abbildet. Ein solches elektronenoptisches Abbildungssystem weist dann mindestens zwei Linsen auf, und der Korrektor ist zwischen diesen Linsen angeordnet.

Nachfolgend wir die Erfindung anhand der in den Figuren dargestellten Ausführungsbeispiele näher erläutert. Im einzelnen zeigen:
- Figur 1: eine Prinzipskizze eines ersten Ausführungsbeispiels des erfindungsgemäßen Korrektors mit dem Verlauf der Fundamentalbahnen innerhalb des Korrektors,
- Figur 2: die Prinzipskizze eines zweiten Ausführungsbeispiels eines Korrektors nach der Erfindung der aus zwei Korrektoren entsprechend der Figur 1 zusammengesetzt ist und
- Figur 3: die Prinzipskizze eines Elektronen-Projektionssystems mit einem Korrektor nach der vorliegenden Erfindung.

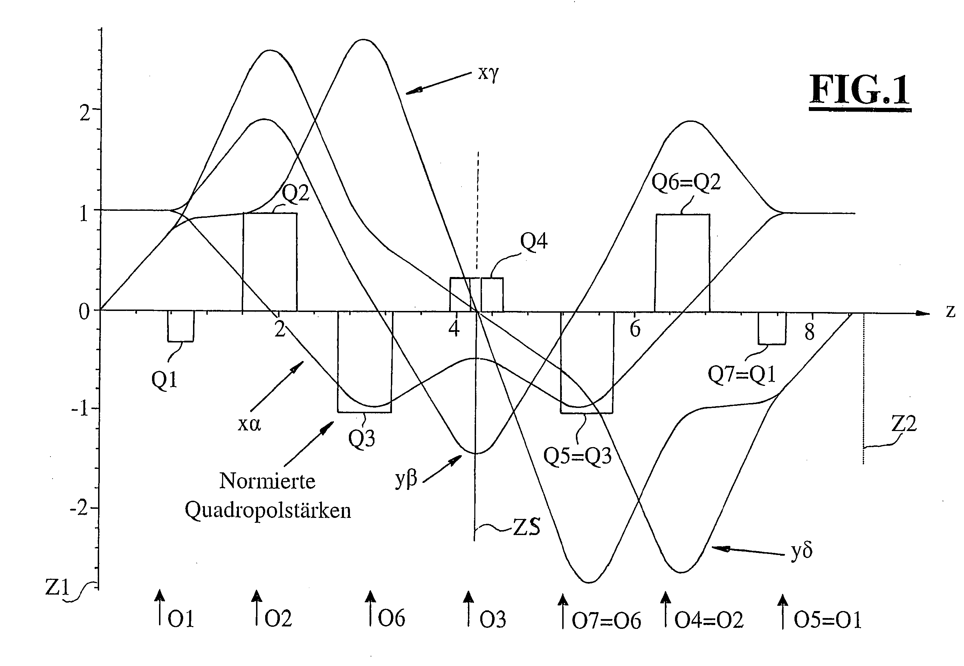

In der Figur 1 sind mit (Q1 - Q7) der Verlauf und die Stärken der entlang einer geraden Achse (Z) erregten Quadrupolfelder (Q1 - Q7) dargestellt. Die Quadrupole (Q1 - Q7) sind symmetrisch zur mittleren Symmetrieebene (ZS). Die Symmetrieebene (ZS) stellt dabei eine Symmetrieebene sowohl hinsichtlich der Qudrupolfelder als auch hinsichtlich der Fundamentalbahnen dar. Als Symmetrieebenen werden dabei Ebenen verstanden, bezüglich der die Quadrupolpotentiale symmetrisch und paraxiale Bahnen symmetrisch oder antisymmetrisch sind.

Ein Teil der Qudrupole (Q1 - Q7), mindestens 3 Quadrupolpaare in jeder der beiden zueinander symmetrischen Hälften des Korrektors, sollte elektrisch-magnetisch sein, also aus der Überlagerung von zueinander senkrechten elektrostatischen und magnetischen Quadrupolfeldern bestehen, um den axialen Farbfehler zu korrigieren. Geeignet dafür sind mit Ausnahme der beiden äußeren Qudrupole (Q1 , Q7) alle übrigen Quadrupole, weil sich dort die Achsenabstände der axialen Fundamentalbahnen (Xα, Yβ) stark unterscheiden. Die Feldbahnen, bzw. außeraxialen Bahnen, sind in üblicherweise mit (Xγ) und (Yδ) bezeichnet. Die Feldbahnen (Xγ, Yδ) sind antisymmetrisch und die axialen Bahnen (Xα, Yβ) sind symmetrisch zur Symmetrieebene (ZS). Die Knotenebenen des teleskopischen Systems des Korrektors sind mit (Z1) bzw. (Z2) bezeichnet. Die Knotenebenen (Z1, Z2) zeichnen sich dadurch aus, dass ein in einer der Knotenebene befindliches Objekt im Abbildungsmaßstab 1:1 in die andere Knotenebene abgebildet wird.

Um die drei Komponenten des Öffnungsfehlers dritter Ordnung zu korrigieren, werden unter Beibehaltung der Symmetrie fünf Okutopole (O1 - 05) benötigt. Die Oktupole (O1 - 05) sind durch die entsprechend bezeichneten Pfeile angedeutet. Die Lagen der einzelnen Oktupole entlang der Achse (Z) sind in Bezug auf den Verlauf der Fundamentalbahnen so gewählt, dass sich die drei Komponenten des Öffnungsfehlers weitgehend unabhängig voneinander korrigieren lassen. Ein Oktupolpaar (O1, 05) ist an Stellen angeordnet, an denen der Strahl weitgehende Rotationssymmetrie hat, wie in Bereichen vor dem ersten Quadrupole (Q1) und hinter dem letzten Quadrupol (Q7). Aus bautechnischen Gründen ist es auch möglich die Oktupole dem ersten und letzten Quadrupol (Q1) und (Q7) zu überlagern. Dadurch wird auch eine Überlagerung des Oktupolfeldes mit einem Rundlinsenfeld vor bzw. hinter dem Korrektor vermieden. Weitere Oktupolpaare (02, 04, 03) sind vorzugsweise in Bereichen astigmatischer Zwischenbilder gelegt, also den Nulldurchgängen einer der Fundamentalbahnen, weil dadurch eine die weitgehende Entkopplung der Fehlerkorrektur gewährleistet ist.

Anstelle eines Oktupols (O3) in der Symmetrieebene (ZS) können auch zwei Oktupole (06, 07) dem dritten bzw. fünften Qudrupol überlagert sein, wie in der Figur 1 gestrichelt angedeutet. Weiterhin ist es möglich, den im Bereich der Symmetrieebene (ZS) angeordneten Qudrupol (Q4) in zwei räumlich getrennte Quadrupole aufzuspalten.

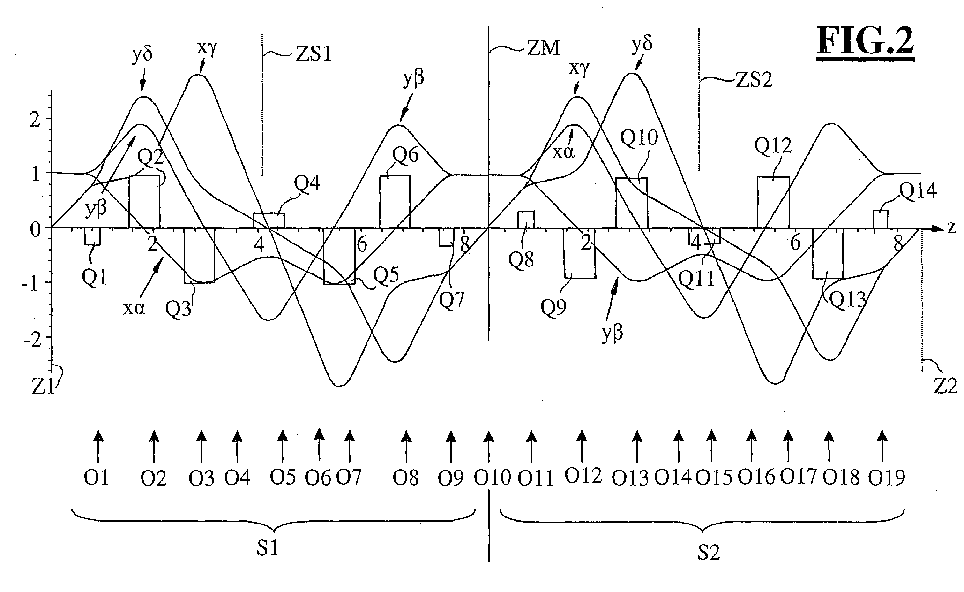

In der Figur 2 ist ein Gesamtsystem dargestellt, das aus zwei Quadrupol-Septuplet-Teilsystemen (S1, S2) entsprechend dem Quadrupol-Septuplet in Figur 1 aufgebaut ist. Jedes dieser Septuplet-Teilsysteme ist symmetrisch zur eigenen Septuplet-Symmetieebene (ZS1, ZS2) aufgebaut, beide Septuplet-Teilsysteme (S1, S2) sind jedoch hinsichtlich der Qudrupolstärken antisymmetrisch zur Mittenebene (ZM) des Gesamtsystems. Das Gesamtsystem hat insgesamt 14 Quadrupole (Q1 - Q14), und 19 Oktupole (O1 - O19). Die Oktupole sind auch hier wieder durch die Pfeile (O1 - 019) angedeutet. Die Antisymmetrie des Gesamtsystems bezüglich der Mittelebene (ZM) bedingt eine Vertauschung der Fundamentalbahnen in den XZ- und YZ-Schnitten der beiden Teilsysteme, d.h. beispielsweise der Verlauf der Xα-Bahn im ersten Septuplet (S1) entspricht dem Verlauf der Yß-Bahn im zweiten Septuplet (S2), und umgekehrt. Das analoge gilt für die Feldbahnen (Yδ) und (Xγ). In Ergänzung zur Figur 1 ermöglicht die Platzierung zusätzlicher Oktupole (04, 06) zwischen dem dritten und vierten Quadrupol (Q3, Q4) und zusätzlich entsprechend der Symmetrie zwischen dem vierten und fünften Quadrupol (Q4, Q5) im ersten Septuplet (S1) und entsprechender symmetrischer Oktupole (O14) und (O16) im zweiten Septuplet (S2) sowie ein Oktupol (O10) in der Mittenebene (ZM) die vollständige Korrektur sämtlicher geometrischer Bildfehler dritter Ordnung. Aufgrund der größeren Anzahl möglicher elektrisch-magnetischer Quadrupole im Ausführungsbeispiel der Figur 2 und der erhöhten Symmetrie können bei diesem Ausführungsbeispiel auch die Farbfehler erster Ordnung, zweiten Grades korrigiert werden, so dass das Gesamtsystem apochromatisch wird.

Die Erregung der Quadrupolfelder erfolgt derart, dass diese eine Zweischnitt-Symmetrie haben, so dass die Hauptschnitte aller Quadrupole in einem gemeinsamen ebenen Schnitt liegen. Ein Schnitt ist dabei eine Fläche, in der die optische Achse liegt. Als Ebenen werden ebene Flächen verstanden, die senkrecht zur optischen Achse liegen, wie z.B. die Symmetrieebenen (ZS1, ZS2) und die Mittelebene (ZM). Durch die Einführung der Symmetrien in den Ebenen und Schnitten wird die Anzahl der linear unabhängigen Fehlerkoeffizienten dritter Ordnung des Quadrupolsystems in Figur 2 auf fünf linear unabhängige Koeffizienten reduziert. Aufgrund der Zweischnitt-Symmetrie hängen die Potentiale der Quadrupole von x² und y² ab (während Rundlinsenpotentiale nur von x² + y² abhängen). Aufgrund der Symmetrie/Antisymmetrie der Fundamentalbahnen verschwinden die azimutalen Fehlerkoeffizienten des Korrektors. In Folge der Antisymmetrie der Feldbahnen und der Symmetrie der axialen Bahnen bezüglich der Symmetrieebenen (ZS1, ZS2) verschwinden alle Terme, die die Summe der Exponenten der Feldbahnen ungerade enthalten, woraus resultiert, dass die Koma und die Verzeichnung sowie die Farbabhängigkeit der Vergrößerung des einzelnen symmetrischen Quadrupolsystems, d.h. eines einzelnen Quadrupol-Septuplets, verschwinden.

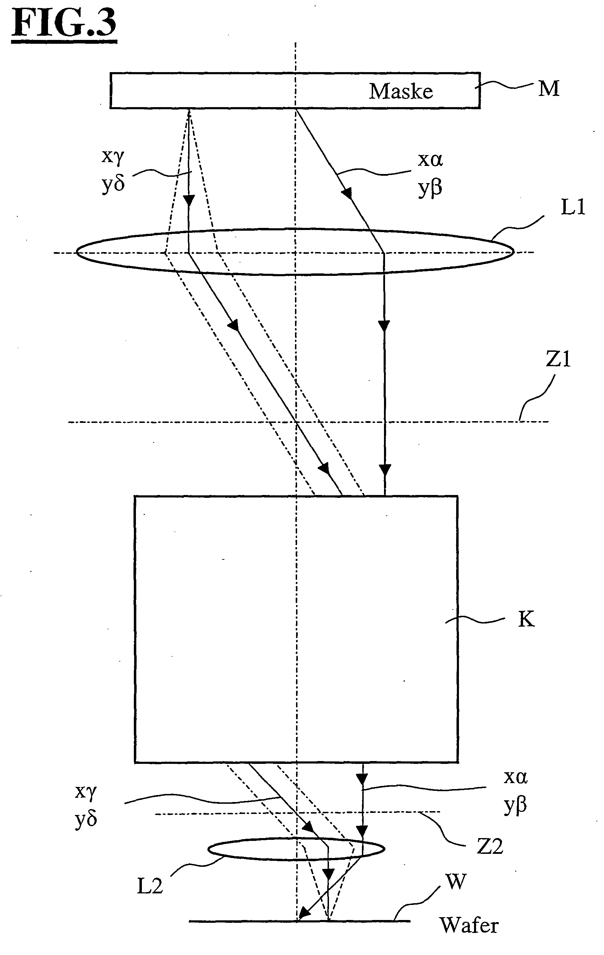

In der Figur 3 ist ein erfindungsgemäßer Korrektor in Verbindung mit einem telezentrischen Duplettsystem, wie es in der Elektronen-Projektionslithographie Anwendung findet, dargestellt. Das telezentrische Duplett enthält eine erste Magnetlinse (L1), in deren vorderen Brennebene die abzubildende Maske (M) angeordnet ist. Die vordere Knotenebene (Z1) des Korrektors fällt mit der hinteren Brennebene der ersten Linse (L1) zusammen. Auf den Korrektor (K) folgt eine zweite Magnetlinse (L2), deren vordere Brennebene mit der hinteren Knotenebene (Z2) des Korrektors (K) zusammenfällt. Das Bild (W) der Maske (M) entsteht in der hinteren Brennebene der zweiten Magnetlinse (L2), in der der zu belichtende Wafer zu positionieren ist. Die Vergrößerung bzw. Verkleinerung des Gesamtsystems ist durch das Verhältnis der Brennweiten der beiden Magnetlinsen (L1) und (L2) bestimmt. Durch Skalierung der Felder der beiden Linsen (L1, L2) entsprechend der Vergrößerung und durch entgegengesetzte Stromrichtungen in beiden Linsen verschwinden die Lamordrehung des Gesamtsystems sowie die isotropen und anisotropen Anteile der Verzeichnung und des Farbfehlers der Vergrößerung.

Durch den Korrektor (K) mit einem Aufbau wie dieser in Figur 2 dargestellt ist, sind sämtliche geometrischen Fehler dritter Ordnung sowie der Farbfehler erster Ordnung, ersten Grades sowie der Farbfehler erster Ordnung, zweiten Grades des Gesamtsystemes korrigierbar. Das Gesamtsystem stellt einen Apochromaten dar, der frei von sämtlichen geometrischen Bildfehlern dritter Ordnung ist. Dieser Apochromat ermöglicht die Abbildung großer Objektfelder bei gleichzeitig relativ großer Energiebreite der abbildenden Elektronen.

Bei der Realisierung des apochromatischen Systemes ist es günstig, den Farbfehler erster Ordnung, ersten Grades nicht vollständig auszukorrigieren, sondern so einzustellen, dass der Restfehler des Farbfehlers erster Ordnung, ersten Grades den verbleibenden Farbfehler erster Ordnung, dritten Grades für eine möglichst große Energiebandbreite möglichst klein hält.

## Patentansprüche

1. Korrektor zur Korrektur des Öffnungsfehlers dritter Ordnung von elektronenoptischen Linsensystemen mit
a) einem ersten Teilsystem (S1), das eine erste Vielzahl an Quadrupolen (Q1 - Q7) und mindesten einen ersten Oktupol (O5) enthält,
b) einem zweiten Teilsystem (S2), das eine zweite Vielzahl an Quadrupolen ((Q8 - Q14) und mindesten einem zweiten Oktupol (O15), und
c) wobei ein Oktupol (O5) des ersten Teilsystems (S1) auf einen Oktupol (O15) des zweiten Teilssystems (S2) abgebildet ist.

2. Korrektor nach Anspruch 1, wobei die Quadrupolfelder des zweiten Teilssystems (S2) antisymmetrisch zu den Quadrupolfeldern des ersten Teilsystems erregbar sind.

3. Korrektor nach Anspruch 1 oder 2, wobei das erste und zweite Teilsystem (S1, S2) geometrisch gleich aufgebaut sind.

4. Korrektor nach einem der Ansprüche 1 - 3, wobei das erste Teilsystem (S1) und das zweite Teilssystem (S2) hintereinander entlang einer geraden optischen Achse angeordnet sind.

5. Korrektor nach Anspruch 4, wobei die Abbildung des Oktupols (O5) des ersten Teilsystems (S1) auf den Oktupol (O15) des zweiten Teilsystems (S2) mit unterschiedlichen Abbildungsmaßstäben in zwei zur optischen Achse senkrechten Richtungen erfolgt.

6. Korrektor nach einem der Ansprüche 1 - 5, wobei das erste und das zweite Teilsystem (S1, S2) gemeinsam eine Mittelebene (ZM) definieren und zwei axiale und/oder zwei außeraxiale Fundamentalbahnen (xα, yβ, yδ,xγ) symmetrisch oder antisymmetrisch zur Mittelebene (ZM) verlaufen.

7. Korrektor nach einem der Ansprüche 1 - 6, wobei die Fundamentalbahnen (xα, yβ) in einem ersten Schnitt im ersten Teilssystem (S 1) dem Verlauf der Fundamentalbahnen (yβ, xα,) in einem zum ersten Schnitt senkrechten Schnitt im zweiten Teilsystem (S2) entsprechen.

8. Korrektor nach einem der Ansprüche 1 - 7, wobei der Oktupol (O5) des ersten Teilsystems (S1) in einer Ebene angeordnet ist, in der zwei Fundamentalbahnen (yδ,xγ) die optische Achse schneiden.

9. Korrektor nach einem der Ansprüche 1 - 8, wobei das erste Teilsystem (S1) eine erste komafreie Ebene (Z1) in eine zwischen dem ersten und zweiten Teilsystem (S1, S2) liegende Mittelebene (ZM) abbildet.

10. Korrektor nach einem der Ansprüche 1 bis 9, wobei das erste Teilsystem (S1) und das zweite Teilsystem (S2) jeweils mindesten 4 Quadrupole enthalten.

11. Korrektor nach Anspruch 10, wobei das erste Teilsystem (S1) und das zweite Teilsystem (S2) jeweils mindestens 7 Quadrupole enthalten.

12. Korrektor nach einem der Ansprüche 1 bis 11, wobei der Korrektor eine eingangsseitige Knotenebene (Z1) in eine ausgangsseitige Knotenebene (Z2) abbildet und die Oktupole (O5, O15) in Zwischenbildebenen der eingangsseitigen Knotenebene (Z1) angeordnet sind.

13. Elektronenoptisches System mit einer elektronenoptischen Linse und einem Korrektor nach einem der Ansprüche 1 bis 12 zur Korrektur von Aberrationen der Linse.

14. Elektronenoptisches System nach Anspruch 13, wobei der Korrektor eine eingangsseitige Knotenebene (Z1) in eine ausgangsseitige Knotenebene (Z2) abbildet, die Oktupole (O5, O15) in Zwischenbildebenen der eingangsseitigen Knotenebene (Z1) angeordnet sind und die eingangsseitige oder ausgangsseitige Knotenebene (Z1, Z2) des Korrektors mit der Beugungsebene der Linse (L1) zusammen fällt.
